# EUROPEAN PATENT APPLICATION

(11) **EP 4 790 896 A2**
(43) Date of publication of application: **12.08.2026**
(21) Application number: 26150470.8
(22) Date of filing: 07.01.2026
(51) Int. Cl.: H03K 3/037, H03K 19/003, H03K 19/007

(54) **LATCHING SYSTEM AND METHOD FOR LOW SOFT ERROR RATE**

(30) Priority: 17.01.2025 US 202519029431
(71) Applicant: Avago Technologies International Sales Pte. Limited, Singapore 768923 (SG)
(72) Inventor: Chandrasekharan, Karthik, Irvine, CA, 92618 (US); Narasimham, Balaji, Irvine, CA, 92618 (US)
(74) Representative: Grünecker Patent- und Rechtsanwälte PartG mbB

(57) **Abstract**

Systems for and methods of reducing soft errors can be utilized in any circuit. A circuit can include a first inverter having a first inverter input and a first inverter output, a second inverter having a second inverter input and a second inverter output, and a soft error hardening circuit. The first inverter input is coupled to the second inverter output, and the second inverter input is coupled to the first inverter output. The clock input is configured to receive a clock signal. The soft error hardening circuit is coupled to the first inverter and/or the second inverter.

## Description

### FIELD OF THE DISCLOSURE

The present disclosure relates generally to mitigating soft errors in integrated circuit (IC) devices including but not limited to systems for and methods of networking (e.g., cloud service gateways (CSG)), processing (e.g., artificial intelligence processing), satellite operations (e.g., receiver and transmitters), storage, sensing, etc.

### BACKGROUND

Processing, storage, sensing, and communications circuits often include IC devices (e.g., memory cells, registers, and latches) for storing data (e.g., often temporarily) or synchronously propagating data. The IC devices can be subject to soft error rate (SER) issues which can affect device reliability. As size and power requirements become more stringent, making IC devices less susceptible to SER issues becomes more challenging.

Soft errors or transient faults generally refer to temporary disruptions in the behavior of IC devices caused by external or internal events. Unlike certain hard errors, soft errors often do not result in permanent damage to the device but can lead to incorrect data or system crashes. Soft errors can be caused by radiation events, charge disturbances, and environmental and process variations. Reduced feature sizes and increased integration density can make IC devices more susceptible to interference from minor charge disturbances that cause soft errors. A soft error can be the result of a transient event that flips or changes a bit in a latch, flip flop, or memory cell (e.g., in an SRAM, DRAM, processor, logic circuit, converter, receiver, transmitter, sensor, etc.).

### BRIEF DESCRIPTION OF THE DRAWINGS

Various objects, aspects, features, and advantages of the disclosure will become more apparent and better understood by referring to the detailed description taken in conjunction with the accompanying drawings, in which like reference characters identify corresponding elements throughout. In the drawings, like reference numbers generally indicate identical, functionally similar, and/or structurally similar elements, and:
FIG. 1 is a general schematic block diagram of a system including a latch according to some embodiments;
FIG. 2 is an electrical schematic drawing of a latch with a data input of 1 and a data output of 0 that can be used in the system illustrated in FIG. 1 according to some embodiments.
FIG. 3 is an electrical schematic drawing of the latch illustrated in FIG. 2 with a data input of 0 and a data output of 1 according to some embodiments; and
FIG. 4 is an electrical schematic drawing of a latch with a data input of 0 and a data output of 1 that can be used in the system illustrated in FIG. 1 according to some embodiments.

### DETAILED DESCRIPTION

Before turning to some features, which illustrate the exemplary embodiments in detail, it should be understood that the application is not limited to the details or methodology set forth in the description or illustrated in the figures. It should also be understood that the terminology is for the purpose of description only and should not be regarded as limiting. Referring generally to the figures, systems for and methods of providing or storing data can be configured to reduce SER even as power specifications and size specifications are reduced in some embodiments. In some embodiments, a low SER is achieved.

A low SER can refer to a rate significantly better than a conventional unhardened design for alpha and neutron particle disruptions.

In some embodiments, an area, power and performance-efficient hardened flip-flop or latch design is configured to meet stringent customer failure-in-time (FIT) specifications. In some embodiments, the systems and methods are hardened with respect to alpha/neutron particles that cause soft errors. In some embodiments, the systems and methods are used in various communication, sensing, and processing system components including but not limited to network switches, data centers, AI processors, satellite communication equipment, converters, other network devices, and/or sensors.

In some embodiments, a diode clamp is used in a latch (e.g., a latch based flip flop) to absorb charges created by particle impact to protect latch critical nodes. Latch nodes are hardened directly by absorbing charges using the diode clamp in some embodiments. A diode is controlled (e.g., turned on/off) by an additional switch to protect a node in some embodiments. In some embodiments, systems and methods use an existing latch transistor in the latch to control the diode, thereby reducing area overhead and cost. In some embodiments, SER hardening is achieved with less power, less area, and cost and with increased performance compared to a dual interlocked storage cell (DICE) latch, a triple modular redundancy (TMR), a hysteresis latch, a charge steering latch, and a miller cap latch technique. In some embodiments, the systems and methods may be used with one or more dual interlocked storage cell (DICE) latch, triple modular redundancy (TMR), hysteresis latch, charge steering latch, and miller cap latch circuits.

In some embodiments, the systems and methods are provided using a 3 nanometer(nm) process. In some embodiments, the systems and methods achieve SER improvements with respect to alpha particle events 200 times better than non-hardened circuits. In some embodiments the systems and methods do not require custom placement and routing (PnR) flows and can be used in automated ASIC flows.

In some embodiments, a latch refers to any circuit that can store information and switch between two stable states. A latch can be a circuit that stores at least one binary state. Latches can be used to store information over time and are often part sequential logic, communication, storage, and processing circuits. The latch can be triggered or clocked by the rising or falling edge of a clock pulse. A latch can change its output immediately based on an applied input. A latch can act like a simple memory element where the output remains stable until a new input signal changes its state. In some embodiments, a latch has two inputs, a set input and a reset input, which control whether the output is set to logic high or low, respectively. A latch may or may not include a clock input.

A flip flop can be a bistable multivibrator that stores binary state information in a physical circuit. A flip flops can include two or more latches and can be data (D) flip flops, reset set (RS) flip flops, etc. A node refers to a location on a circuit in some embodiments, A node can be a junction point where two or more components (e.g., conductors, transistors, diodes, capacitors, or resistors) connect.

Some embodiments relate to a circuit including a first inverter having a first inverter input and a first inverter output, a second inverter having a second inverter input, a clock input, and a second inverter output, and a soft error hardening circuit. The first inverter input is coupled to the second inverter output, and the second inverter input is coupled to the first inverter output. The clock input is configured to receive a clock signal. The soft error hardening circuit is coupled to the first inverter and the second inverter. An inverter may refer to a circuit that implements logical negation or signal inversion in some embodiments. The inverter can be a logic gate that outputs a bit opposite of the bit that is input. The inverter can be but is not limited to an NMOS inverter, a PMOS inverter, a CMOS inverter, an NPN resistor-transistor logic inverter, an NPN transistor-transistor logic inverter, etc.

In some embodiments, the clock input incudes a first phase input and a second phase input, and the circuit is configured so that the clock signal is provided to the first phase input and an inverted clock signal is provided to the second phase input. In some embodiments, the first inverter includes a first pair of first transistors and a second pair of second transistors coupled in series. Gates of the first pair and the second pair are coupled to the first inverter input. In some embodiments, a node between the first pair and the second pair are coupled to the second inverter input.

In some embodiments, the second inverter includes a third pair of third transistors and a fourth pair of fourth transistors coupled in series. One gate of gates of the third pair and one gate of gates of the second pair are coupled to the first inverter output. In some embodiments, the clock input includes a first phase input and a second phase input. The clock signal is provided to the first phase input and an inverted clock signal is provided to the second phase input. One gate of gates of the third pair is coupled to the first phase input, and one gate of gates of the second pair is coupled to the second phase input.

In some embodiments, the soft error hardening circuit includes a first diode coupled to a node between the third pair of the third transistors. In some embodiments, the soft error hardening circuit includes a second diode coupled to a node between the fourth pair of the fourth transistors. In some embodiments, the soft error hardening circuit includes a third diode coupled to a node between the first pair of the first transistors and a fourth diode coupled to a node between the fourth pair of the fourth transistors. In some embodiments, the first diode, the second diode, the third diode, and the fourth diode are each coupled to a respective switch controlled by a data signal at the first inverter input or the first inverter output, or the first diode is coupled to the node between the fourth pair of the fourth transistors, the second diode is coupled to the node between the third pair of the third transistors, the third diode is coupled to the node between the second pair of the second transistors, and the fourth diode is coupled to the node between the first pair of the first transistors. In some embodiments, a pair refers to a set including two or more. Members of the set can have identical characteristics or non-identical characteristics.

Some embodiments relate to a circuit including a first inverter, a second inverter and a soft error hardening circuit. The first inverter has a first inverter input and a first inverter output. The first inverter includes a first pair of first transistors and a second pair of second transistors coupled in series. Gates of the first pair and the second pair are coupled to the first inverter input. A first node is between the first pair of the first transistors, and a second node is between the second pair of the second transistors. The second inverter has a second inverter input and a second inverter output. The first inverter input is coupled to the second inverter output, and the second inverter input is coupled to the first inverter output. The soft error hardening circuit is coupled to the first node and/or the second node.

In some embodiments, the first transistors are P-channel transistors and the second transistors are N-channel transistors. In some embodiments, the soft error hardening circuit includes a first diode coupled to the first node and a second diode coupled to the second node. In some embodiments, the first diode is an N-channel diode and the second diode is a P-channel diode. In some embodiments, the first diode is coupled between the first node and the second node. In some embodiments, the first diode is coupled to a switch coupled to a ground node.

Some embodiments relate to a circuit. The circuit includes a first inverter having a first inverter input and a first inverter output. The first inverter includes a first pair of first transistors and a second pair of second transistors coupled in series, and gates of the first pair and the second pair are coupled to the first inverter input. The circuit also includes a second inverter having a second inverter input and a second inverter output. The first inverter input is coupled to the second inverter output. The second inverter input is coupled to the first inverter output. The circuit also includes a soft error hardening circuit including one or more diodes. The circuit is configured so that a first diode is switched on and off by a data state provided to the first inverter input or the second inverter input.

In some embodiments, the first diode includes an NMOS or PMOS transistor configured to be switched on and off by the data state to provide no contention during latch operation. In some embodiments, a first node is between the first pair of the first transistors and a second node is between the second pair of the second transistors.

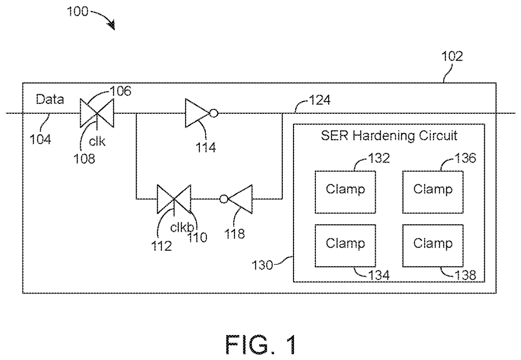

With reference to FIG. 1, a latch 102 can embodied as a clocked latch. Latch 102 can be a part of an IC device 100 such as a network device, a processor, a memory, a transmitter, a receiver, a converter, sensor, or other electronic device. Latch 102 includes a data input 104, a clocked pass gate 106, an inverter 114, an inverter 118, a clocked pass gate 110 and a soft error rate (SER) hardening circuit 130. In some embodiments, latch 102 is configured for easy integration into multi-bit pulse latch circuits and to achieve better performance/density.

Latch 102 is configured to be less susceptible to soft rate errors. Although hardening circuit 130 is included with latch 102 (e.g., a circuit with cross coupled inverters 114 and 118 in FIG. 1), hardening circuit 130 can be used with other types of logic circuits, flip flops, latches, registers, memory cells, converters, etc. In some embodiments, hardening circuit 130 reduces the effects of charge particles affecting nodes associated with inverters 114 and 118. In some embodiments, hardening circuit 130 is configured to reduce area overhead of hardening circuitry by at least 25% due to fewer power to ground (VDD - VSS) cross routes and improves performance by 30% due to absence of hysteresis.

Inverters 114 and 118 are cross coupled between data input 104 and a data output 124 (e.g., stacked back to back inverters) in some embodiments. The signal or bit provided at data input 104 is provided to an input of inverter 114 when a clock signal is provided at a clock input 108 of pass gate 106. A bit refers to an electronic signal representative of a one or a zero in some embodiments. The representation can be a direct current voltage level. Pass gate 106 is controlled by the clock signal at input 108.

Inverter 114 inverts the signal at its input and provides an inverted signal at data output 124. An inverted signal refers to a signal that has an opposite relationship or is in a 180 degrees out of phase relationship with a respective signal in some embodiments. A bit representing a value of 1 can be inverted to represent a value of zero and vice versa in some embodiments.

Inverter 118 receives the inverted signal at data output 124 and provides an inverted signal of the inverted signal to pass gate 110. The inverted signal from inverter 118 is provide through pass gate 110 to the input of inverter 114 when an inverted clock signal is provided to pass gate 110. Pass gate 110 is controlled by the inverted clock signal at an input 112.

Pass gates 110 and 106 are electronic switches or switch circuits controlled by the clock signal in some embodiments. Pass gates 110 and 106 are configured to control the flow of electrical signals or current through pathways associated with inverters 114 and 118 and can act as a gate that can either allow or block the signal. Pass gates 110 and 106 can be implemented using semiconductor devices (e.g., transistors such as, metal oxide semiconductor field effect transistor based (MOSFET-Based) devices). For example, pass gates 110 and 106 can be negative metal oxide semiconductor (NMOS) transistors, positive metal oxide semiconductor (PMOS) transistors, combinations thereof, and/or bipolar junction transistors (BJT).

A switch may refer to any type of switching device including but not limited to transistors in some embodiments. A transistor may refer to a switch including doped regions in some embodiments. A transistor can be any type of transistor including but not limited to field effect transistors FETS, insulated gate FETs, bipolar junction transistors, etc. In some embodiments, the transistors are P-channel (e.g., PMOS) or N-channel (E.g., NMOS) metal oxide semiconductor field effect transistors (MOSFETs). A P-channel transistor includes a P channel, which is a channel composed of a majority of hole current carriers, between its source and drain. An N-channel transistor includes an N channel, which is a channel composed of a majority of electron current carriers, between its source and drain. The terms drain and source may be used interchangeably and may refer to a region of a transistor in some embodiments. A gate may refer to a transistor structure for controlling opening (e.g., towards a non-conductive state) and closing (e.g., towards a conductive state) of a transistor in some embodiments. The terms drain and source can be applied to a bipolar junction transistor as a collector and emitter and the term gate can be applied to a bipolar junction transistor as a base in some embodiments.

A diode may refer to an electronic component that primarily allows current to flow in one direction, while blocking current in the opposite direction in some embodiments. A MOSFET diode generally refers to a MOSFET transistor configured as a diode in some embodiments, A MOSFET diode is configured to use the inherent diode-like behavior of a MOSFET due to its internal structure. In some embodiments, diode operation is provided between the drain and source, with the body acting as one terminal. The gate can be coupled to the drain or source to provide a PN junction in the physical structure of the MOSFET in some embodiments. An N-channel or NMOS MOSFET diode refers to a diode formed using an N-channel MOSFET, and a P-channel or PMOS MOSFET diode refers to a diode formed using a P-channel MOSFET in some embodiments.

Hardening circuit 130 includes one or more clamp circuits 132, 134, 136, and 138 in some embodiments. The number of clamp circuits 132, 134, 136, and 138 can be chosen based on system criteria, configuration of latch 102, device area requirements, desired robustness, the number of transistors to be protected, etc. In some embodiments, one or more of clamp circuits 132, 134, 136, and 138 are configured to provide a diode clamp that absorbs charges created by particle impacts to protect latch operation at nodes associated with inverters 114 and 118 (e.g., data output, input of inverter 114, etc.). In some embodiments, one or more of clamp circuits 132, 134, 136, and 138 are configured to divert charge. In some embodiments, one or more of clamp circuits 132, 134, 136, and 138 are configured as an NMOS diode clamp for off state PMOS transistors and as a PMOS diode clamp for off state NMOS transistors. The diode clamp transistors are switched on/off by in a hold phase (e.g., when the clock signal at a clock input 108 does not close gates 106 and 110) by data state (e.g., at an intermedia node associated with inverters 114 and 118), thereby enabling no contention operation. No contention in a write phase of latch102 improves yield and performance. No contention refers to a characteristic where the diode clamps do not affect storage and provision of a bit by latch 102 (e.g., do not affect latch operation) in some embodiments.

In some embodiments, inverters 114 and 118 are configured for improved SER latch/flip flop operation as two stacked inverters connected in back to back configuration. Inverter 118 can be driven by a clock signal as well as an output of inverter 114 and inverter 114 can be completely driven by an output of inverter 118. In some embodiments, intermediate nodes of inverters 114 and 118 are connected to NMOS and PMOS diode clamp transistors of hardening circuit 130 which provide low impedance path to absorb charge, thereby mitigating the effect of impact of a particle such as alpha/neutron/heavy ion. In some embodiments, the diode clamp NMOS and PMOS transistors are switched on/off by data state such that there is no contention during latch operation.

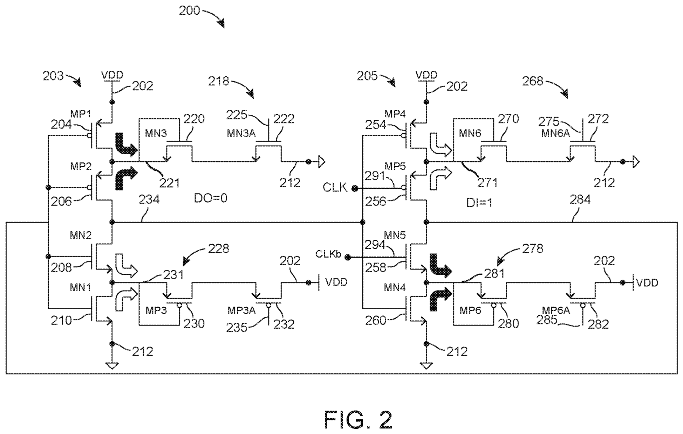

With reference to FIG. 2, a latch 200 which can be used as latch 102 (FIG. 1) includes an inverter 203 and an inverter 205. Inverters 203 and 205 are similar to inverters 118 and 114, respectively, in some embodiments. An input of inverter 203 and an output of inverter 205 are coupled together by a conductor 284, and an output of inverter 203 is coupled to an input of inverter 205 by a conductor 234 in some embodiments. Latch 200 is configured to be less susceptible to soft rate errors and includes a clamp circuit 218, a clamp circuit 228, a clamp circuit 268, and a clamp circuit 278. Clamp circuit 218, clamp circuit 228, clamp circuit 268, and clamp circuit 278 provide SER hardening in some embodiments (e.g., an SER hardening circuit). An SER hardening circuit refers to any circuit that is configured to reduce soft errors or soft error rates in another circuit in some embodiments. A soft error hardening circuit refers to a circuit configured to reduce soft errors and/or soft error rates or mitigate effects of such errors in some embodiments. A soft hardening circuit can make a circuit more resilient to transient disruptions in data. A soft hardening circuit can use techniques such as redundancy (e.g., triple modular redundancy - TMR), error detection and correction mechanisms, wider design margins, clamping, and optimized layout strategies to minimize the impact of soft errors. A circuit that reduces other errors as well as soft errors is soft error hardening circuit in some embodiments. The soft errors can be from any source including but not limited to alpha particles, neutrons, heavy ions, or other charged particles.

Inverter 203 includes a transistor 204, a transistor 206, a transistor 208, and a transistor 210 configured as a CMOS inverter coupled between a power signal VDD at node 202 and a ground signal at a node 212 in some embodiments. Transistors 204 and 206 are PMOSFETS, and transistors 208 and 210 are NMOSFETS in some embodiments.

The power signal refers to a signal that provides power (e.g., form a power supply. The power signal can be provided at a node, such as a VDD node. Node 202 can be specific points in the circuit where the power signal is present. The power signal can be provided by a main power supply in some embodiments. The ground signal refers to a signal that provides a low voltage or 0 voltage reference in some embodiments. power (e.g., form a power supply. The ground signal can be provided at a node, such as a GND or VSS node. Node 212 can be specific points in the circuit where the ground signal is present. The ground signal can be provided by a main power supply in some embodiments.

Inverter 205 includes a transistor 254, a transistor 256, a transistor 258, and a transistor 260 configured as a CMOS inverter in some embodiments. Inverter 205 receives the data input at the gates of transistors 254 and 260 at conductor 234 and provides the data output at conductor 284. Transistors 254 and 256 are PMOSFETS, and transistors 258 and 260 are NMOSFETS in some embodiments. The gates of transistors 204, 206, 208, and 210 are coupled to conductor 284. The gates of transistors 254 and 260 are couped to conductor 234, and gates 291 and 294 of respective transistors 256 and 258 are coupled to receive a clock signal and an inverted clock signal (CLK and CLKb) in some embodiments. A clock signal may refer to any signal used for synchronization in a circuit in some embodiments. The clock signal can be a periodic electrical signal that oscillates between high and low voltage states at a constant frequency in some embodiments. The clock signal can be a square wave signal with a 50 percent duty cycle in some embodiments. The clock signal can have a signal phase or multiple phases and can be a gated signal or a combination of signals in some embodiments.

Clamp circuits 218, 228, 268, and 278 each include diode clamps (e.g., MOSFET diodes) 220, 230, 270, and 280, respectively and a pass or gate transistor 222, 232, 272, and 282, respectively. Clamp circuits 218 and 268 include NMOSFETS, and clamp circuits 228 and 278 include PMOSFETS in some embodiments. Diode clamps 220, 230, 270, and 280 are serially connected to respective gate transistors 222, 232, 272 and 282. Diode clamp 220 is coupled to a node 221 between transistors 204 and 206 in some embodiments. Diode clamp 230 is coupled to a node 231 between transistors 208 and 210 in some embodiments. Diode clamp 270 is coupled to a node 271 between transistors 254 and 256 in some embodiments. Diode clamp 280 is coupled to a node 281 between transistors 258 and 260 in some embodiments. A diode clamp can refer to any diode circuit used to protect operation of a circuit in some embodiments. A diode clamp can include a diode configured to absorb charge to harden a circuit against soft errors in some embodiments.

Pass or gate transistors 222, 232, 272 and 282 include a respective gate 225, 235, 275, and 285 couple to receive a signal which opens and closes gate transistors 222, 232, 272 and 282 to nodes 212 or 202. In some embodiments, gates 225 and 235 are coupled to receive the signal at conductor 284 (e.g., the data input signal). In some embodiments, gates 275 and 285 are coupled to receive the signal at conductor 234 (e.g., the data output signal). In some embodiments, clamp circuits 218, 228, 268, and 278 are configured to provide a diode clamp that absorbs charges created by particle impacts to protect latch operation at nodes (e.g., nodes 221, 231, 271, and 281) associated with inverters 203 and 205. In some embodiments, clamp circuits 218, 228, 268, and 278 are configured to divert charge. In some embodiments, clamp circuits 218 and 268 are configured as NMOS diode clamps for the off state PMOS transistors 204 and 206 and the off state PMOS transistors 254 and 256, respectively. In some embodiments, clamp circuits 228 and 278 are configured as PMOS diode clamps for off state NMOS transistors 208 and 210 and the off state NMOS transistors 258 and 260, respectively.

Clamp circuits 218, 228, 268, and 278 each include diode clamps (e.g., MOSFET diodes) 220, 230, 270, and 280, respectively. The diode clamp transistors are switched on/off in a hold phase (e.g., when the clock signal at a phase clock input (e.g., gate 291) does not close transistor 256) by data state (e.g., at an intermedia node associated with inverters 114 and 118 or at conductors 234 and 284), thereby enabling no contention operation. A phase clock input refers to an input for receiving a clock signal of a particular phases (e.g., a non-inverted clock signal). No contention in a write phase of latch 102 improves yield and performance.

Exemplary operation of latch 200 with SER hardening is described below as follows according to some embodiments. A data state or bit representing one (e.g., a logic 1) is provided to conductor 284 in some embodiments. The logic 1 turns off transistors 204 and 206 and turns on transistors 208 and 210, thereby providing a logic 0 to conductor 234. Diode clamp 220 is turned on and provides a path to the ground signal at node 212 via transistor 222. Transistor 222 is turned on by the signal at gate 225. The signal at gate 225 is provided by conductor 284 which is a logic 1. Diode clamp 230 is turned off because transistors 208 and 210 are turned on and the logic 1 at gate 235 turns transistor 232 off. Gate 235 is coupled to conductor 284. Turning diode clamp 220 on protects operation of transistors 204 and 208 which are turned off from being turned on by a charged particle or neutron. Protection of transistors operation of transistors 204 and 208 which are turned on is not required when a logic 1 is provided at conductor 284.

The logic 0 at conductor 234 turns on transistor 254 and turns off transistor 260. Transistors 256 and 258 are controlled by respective clock and inverted clock signal at respective gates 291 and 294 (clock phase inputs). Diode clamp 270 is turned off because transistor 272 is turned off. Gate 275 is coupled to conductor 234 which is a logic 0. Protection of operation of transistor 254 which is turned on is not required when a logic 0 is provided at conductor 234. Diode clamp 280 is turned on by turning on transistor 282. Turning diode clamp 280 on protects operation of transistor 260 which is turned off from being turned on by a charged particle or neutron. Diode clamp 280 is turned on by the logic zero at conductor 234 which is coupled to gate 285 of transistor 282. Turning transistor 282 on provides a path for the power signal at node 202 to node 281 between transistor 258 and 260.

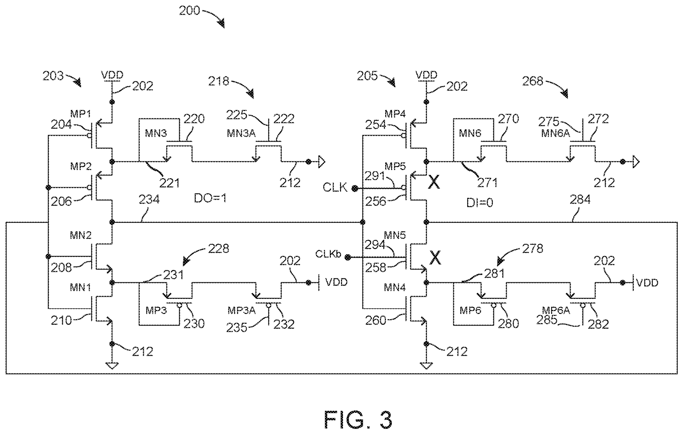

With reference to FIG. 3, data state or bit representing zero (e.g., a logic 0) is provided to conductor 284 in some embodiments. The logic 0 turns on transistors 204 and 206 on and turns off transistors 208 and 210, thereby providing a logic 1 to conductor 234. Diode clamp 220 is turned off and does not provide a path to node 212 via transistor 222. Transistor 222 is turned off by the signal at gate 225. The signal at gate 225 is provided by conductor 284 which is a logic 0. Diode clamp 230 is turned on because transistors 208 and 210 are turned off and the logic 0 at gate 235 turns on transistor 232 providing a path from node 202 to node 231 between transistors 208 and 210. Gate 235 is coupled to conductor 284. Turning diode clamp 230 on protects operation of transistors 208 and 210 which are turned off from being turned on by a charged particle or neutron. Protection of operation of transistors 204 and 206 which are turned on is not required when a logic 0 is provided at conductor 284.

The logic 1 at conductor 234 turns off transistor 254. Diode clamp 270 is turned ON because the logic 1 at gate 275 turns on transistor 272. Gate 275 is coupled to conductor 234. Turning on transistor 272 provides a path from node 212 to node 271 between transistor 254 and 256. Protection of operation of transistors 258 and 260 which are turned on is not required when a logic 1 is provided at conductor 234. Diode clamp 280 is turned off because transistor 282 is turned off by the signal on conductor 234.

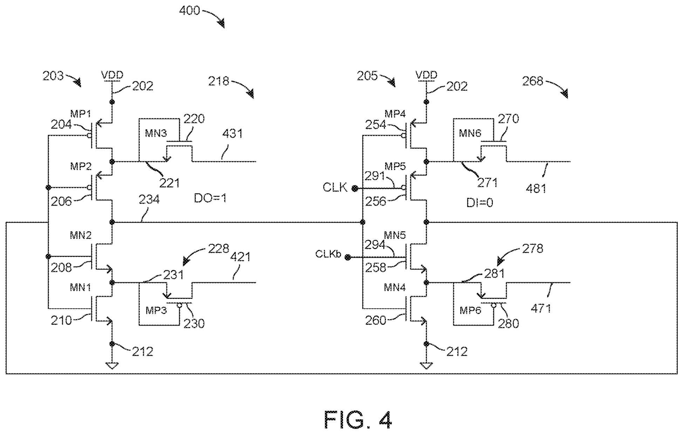

With reference to FIG. 4, a latch 400 is similar to latch 200. Latch 400 does not include transistors 222, 233, 272 and 282 (FIGS. 2 and 3). Conductor 431 is coupled to diode clamp 220 and a node between transistors 208 and 210 (node 231). Conductor 421 is coupled to diode clamp 230 and a node between transistors 204 and 206 (nodes 221). Conductor 481 is coupled to transistor 270 and a node between transistors 258 and 260 (node 281). Conductor 471 is coupled to transistor 270 and a node between transistors 254 and 256 (node 271). Conductors 431, 421, 481, and 471 turn on and off diode clamps 220, 230, 270 and 280, respectively, without requiring an extra transistor. The configuration of inverters 203 and 205 provide a transistor for providing the operation of transistors 222, 233, 272 and 282 (FIGS. 2 and 3).

When conductor 234 is a logic 1, diode clamp 230 is turned on via conductor 421 which is coupled to node 202 through transistor 204 which is turned on. When conductor 234 is a logic 1, diode clamp 270 is turned on via conductor 481 which is coupled to node 212 through transistor 260 which is turned on. Diode clamps 280 and 220 are turned off.

When conductor 234 is a logic 0, diode clamp 220 is turned on via conductor 431 which is coupled to node 212 through transistor 210 which is turned on. When conductor 234 is a logic 0, diode clamp 280 is turned on via conductor 471 which is coupled to node 212 through transistor 254 which is turned on.

The disclosure is described above with reference to drawings. These drawings illustrate certain details of specific embodiments that implement the systems and methods and programs of the present disclosure. However, describing the disclosure with drawings should not be construed as imposing on the disclosure any limitations that are present in the drawings. No claim element herein is to be construed as a "means plus function" element unless the element is expressly recited using the phrase "means for." Furthermore, no element, component or method step in the present disclosure is intended to be dedicated to the public, regardless of whether the element, component or method step is explicitly recited in the claims.

It should be noted that certain passages of this disclosure can reference terms such as "first" and "second" in connection with power level for purposes of identifying or differentiating one from another or from others. These terms are not intended to relate entities or operations (e.g., a first power level and a second power level) temporally or according to a sequence, although in some cases, these entities can include such a relationship. Nor do these terms limit the number of possible entities or operations.

Any implementation disclosed herein can be combined with any other implementation, and references to "an implementation," "some embodiments," "an alternate implementation," "various implementation," "one implementation" or the like are not necessarily mutually exclusive and are intended to indicate that a particular feature, structure, or characteristic described in connection with the implementation can be included in at least one implementation. Such terms as used herein are not necessarily all referring to the same implementation. Any implementation can be combined with any other implementation, inclusively or exclusively, in any manner consistent with the aspects and embodiments disclosed herein. In the above description, for the purposes of explanation, numerous details are set forth to provide a thorough understanding of the described embodiments. It will be apparent to one skilled in the art, however, that other embodiments may be practiced without some of these details. In other instances, structures and devices are shown in block diagram form. Several embodiments are described herein, and while various features are ascribed to different embodiments, it should be appreciated that the features described with respect to one embodiment may be incorporated with other embodiments as well. By the same token, however, no single feature or features of any described embodiment should be considered essential to every embodiment of the invention, as other embodiments of the invention may omit such features. Similarly, when an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present. Circuit or circuitry may refer to any active or passive component and connections thereto as well as combinations thereof. Circuitry may further include or access instructions (e.g., software or firmware instructions) for execution by the circuitry. The circuitry may include discrete interconnected hardware components and/or may be combined on a single integrated circuit die, distributed among multiple integrated circuit dies, or implemented in a Multiple Chip Module (MCM) of multiple integrated circuit dies in a common package, as examples. The integrated circuit package can be a combination of two or more packages in some embodiments.

While the foregoing written description of the methods and systems enables one of ordinary skill to make and use what is considered presently to be the best mode thereof, those of ordinary skill will understand and appreciate the existence of variations, combinations, and equivalents of the specific embodiment, method, and examples herein. The present methods and systems should therefore not be limited by the above described embodiments, methods, and examples, but by all embodiments and methods within the scope and spirit of the disclosure.
The following are further embodiments of the invention:
1. A circuit, comprising:
   a first inverter having a first inverter input and a first inverter output;
   a second inverter having a second inverter input, a clock input, and a second inverter output, the first inverter input being coupled to the second inverter output, the second inverter input being coupled to the first inverter output, the clock input being configured to receive a clock signal; and
   a soft error hardening circuit coupled to the first inverter and the second inverter.
2. The circuit of embodiment 1, wherein the clock input comprises a first phase input and a second phase input, wherein the circuit is configured so that the clock signal is provided to the first phase input and an inverted clock signal is provided to the second phase input.
3. The circuit of embodiment 1, wherein the first inverter is comprised of a first pair of first transistors and a second pair of second transistors coupled in series, wherein gates of the first pair and the second pair are coupled to the first inverter input.
4. The circuit of embodiment 3, wherein a node between the first pair and the second pair are coupled to the second inverter input.
5. The circuit of embodiment 4, wherein the second inverter is comprised of a third pair of third transistors and a fourth pair of fourth transistors coupled in series, wherein one gate of gates of the third pair and one gate of gates of the second pair are coupled to the first inverter output.
6. The circuit of embodiment 5, wherein the clock input comprises a first phase input and a second phase input, wherein the clock signal is provided to the first phase input and an inverted clock signal is provided to the second phase input, wherein one gate of gates of the third pair is coupled to the first phase input and one gate of gates of the second pair is coupled to the second phase input.
7. The circuit of embodiment 5, wherein the soft error hardening circuit comprises a first diode coupled to a node between the third pair of the third transistors.
8. The circuit of embodiment 7, wherein the soft error hardening circuit comprises a second diode coupled to a node between the fourth pair of the fourth transistors.
9. The circuit of embodiment 8, wherein the soft error hardening circuit comprises a third diode coupled to a node between the first pair of the first transistors and a fourth diode coupled to a node between the fourth pair of the fourth transistors.
10. The circuit of embodiment 9, wherein the first diode, the second diode, the third diode , and the fourth diode are each coupled to a respective switch controlled by a data signal at the first inverter input or the first inverter output; or
   wherein the first diode is coupled to the node between the fourth pair of the fourth transistors, the second diode is coupled to the node between the third pair of the third transistors, the third diode is coupled to the node between the second pair of the second transistors, and the fourth diode is coupled to the node between the first pair of the first transistors.
11. A circuit, comprising:
   a first inverter having a first inverter input and a first inverter output, wherein the first inverter is comprised of a first pair of first transistors and a second pair of second transistors coupled in series, wherein gates of the first pair and the second pair are coupled to the first inverter input and wherein a first node is between the first pair of the first transistors and a second node is between the second pair of the second transistors;
   a second inverter having a second inverter input, and a second inverter output, the first inverter input being coupled to the second inverter output, the second inverter input being coupled to the first inverter output; and
   a soft error hardening circuit coupled to the first node or the second node or to both the first node and the second node.
12. The circuit of embodiment 11, wherein the first transistors are P-channel transistors and the second transistors are N-channel transistors.
13. The circuit of embodiment 12, wherein the soft error hardening circuit comprises a first diode is coupled to the first node and a second diode coupled to the second node.
14. The circuit of embodiment 13, wherein the first diode is an N-channel diode and the second diode is a P-channel diode.
15. The circuit of embodiment 13, wherein the first diode is coupled between the first node and the second node.
16. The circuit of embodiment 13, wherein the first diode is coupled to a switch coupled to a ground node.
17. A circuit, comprising:
   a first inverter having a first inverter input and a first inverter output, wherein the first inverter is comprised of a first pair of first transistors and a second pair of second transistors coupled in series, wherein gates of the first pair and the second pair are coupled to the first inverter input;
   a second inverter having a second inverter input, and a second inverter output, the first inverter input being coupled to the second inverter output, the second inverter input being coupled to the first inverter output; and
   a soft error hardening circuit comprising one or more diodes, wherein the circuit is configured so that a first diode is switched on and off by a data state provided to the first inverter input or the second inverter input.
18. The circuit of embodiment 17, wherein the first diode comprises an NMOS or PMOS transistor and the circuit is configured so that the first diode is switched on and off by the data state to provide no contention during latch operation.
19. The circuit of embodiment 17, wherein a first node is between the first pair of the first transistors and a second node is between the second pair of the second transistors and the first diode is coupled to the first node and a second diode is coupled to the second node.
20. The circuit of embodiment 17 wherein a first node is between the first pair of the first transistors, a second node is between the second pair of the second transistors, and the first diode is coupled between the first node and the second node.

## Claims

1. A circuit, comprising:
a first inverter having a first inverter input and a first inverter output;
a second inverter having a second inverter input, a clock input, and a second inverter output, the first inverter input being coupled to the second inverter output, the second inverter input being coupled to the first inverter output, the clock input being configured to receive a clock signal; and
a soft error hardening circuit coupled to the first inverter and the second inverter.

2. The circuit of claim 1, wherein the clock input comprises a first phase input and a second phase input, wherein the circuit is configured so that the clock signal is provided to the first phase input and an inverted clock signal is provided to the second phase input.

3. The circuit of claim 1 or 2, wherein the first inverter is comprised of a first pair of first transistors and a second pair of second transistors coupled in series, wherein gates of the first pair and the second pair are coupled to the first inverter input.

4. The circuit of claim 3, wherein a node between the first pair and the second pair are coupled to the second inverter input.

5. The circuit of claim 4, wherein the second inverter is comprised of a third pair of third transistors and a fourth pair of fourth transistors coupled in series, wherein one gate of gates of the third pair and one gate of gates of the second pair are coupled to the first inverter output.

6. The circuit of claim 5, wherein the clock input comprises a first phase input and a second phase input, wherein the clock signal is provided to the first phase input and an inverted clock signal is provided to the second phase input, wherein one gate of gates of the third pair is coupled to the first phase input and one gate of gates of the second pair is coupled to the second phase input.

7. The circuit of claim 5 or 6, wherein the soft error hardening circuit comprises a first diode coupled to a node between the third pair of the third transistors.

8. The circuit of claim 7, wherein the soft error hardening circuit comprises a second diode coupled to a node between the fourth pair of the fourth transistors.

9. The circuit of claim 8, wherein the soft error hardening circuit comprises a third diode coupled to a node between the first pair of the first transistors and a fourth diode coupled to a node between the fourth pair of the fourth transistors,
in particular,
wherein the first diode, the second diode, the third diode , and the fourth diode are each coupled to a respective switch controlled by a data signal at the first inverter input or the first inverter output; or
wherein the first diode is coupled to the node between the fourth pair of the fourth transistors, the second diode is coupled to the node between the third pair of the third transistors, the third diode is coupled to the node between the second pair of the second transistors, and the fourth diode is coupled to the node between the first pair of the first transistors.

10. A circuit, comprising:
a first inverter having a first inverter input and a first inverter output, wherein the first inverter is comprised of a first pair of first transistors and a second pair of second transistors coupled in series, wherein gates of the first pair and the second pair are coupled to the first inverter input and wherein a first node is between the first pair of the first transistors and a second node is between the second pair of the second transistors;
a second inverter having a second inverter input, and a second inverter output, the first inverter input being coupled to the second inverter output, the second inverter input being coupled to the first inverter output; and
a soft error hardening circuit coupled to the first node or the second node or to both the first node and the second node.

11. The circuit of claim 10, wherein the first transistors are P-channel transistors and the second transistors are N-channel transistors.

12. The circuit of claim 11, wherein the soft error hardening circuit comprises a first diode is coupled to the first node and a second diode coupled to the second node,
in particular,
wherein the first diode is an N-channel diode and the second diode is a P-channel diode.

13. The circuit of claim 12, wherein the first diode is coupled between the first node and the second node
and/or
wherein the first diode is coupled to a switch coupled to a ground node.

14. A circuit, comprising:
a first inverter having a first inverter input and a first inverter output, wherein the first inverter is comprised of a first pair of first transistors and a second pair of second transistors coupled in series, wherein gates of the first pair and the second pair are coupled to the first inverter input;
a second inverter having a second inverter input, and a second inverter output, the first inverter input being coupled to the second inverter output, the second inverter input being coupled to the first inverter output; and
a soft error hardening circuit comprising one or more diodes, wherein the circuit is configured so that a first diode is switched on and off by a data state provided to the first inverter input or the second inverter input.

15. The circuit of claim 14, wherein the first diode comprises an NMOS or PMOS transistor and the circuit is configured so that the first diode is switched on and off by the data state to provide no contention during latch operation
and/or
wherein a first node is between the first pair of the first transistors and a second node is between the second pair of the second transistors and the first diode is coupled to the first node and a second diode is coupled to the second node
and/or
wherein a first node is between the first pair of the first transistors, a second node is between the second pair of the second transistors, and the first diode is coupled between the first node and the second node.
